Europäisches Patentamt

European Patent Office

Office européen des brevets

(19)

(11) Numéro de publication : **0 413 643 B1**

(12) **FASCICULE DE BREVET EUROPEEN**

(45) Date de publication du fascicule du brevet :
**20.10.93 Bulletin 93/42**

(51) Int. Cl.$^5$ : **H03F 3/72**

(21) Numéro de dépôt : **90420372.6**

(22) Date de dépôt : **09.08.90**

(54) **Circuit d'amplification à impédance d'entrée déterminée et à différentes valeurs de transconductance.**

(30) Priorité : **16.08.89 FR 8911226**

(43) Date de publication de la demande :
**20.02.91 Bulletin 91/08**

(45) Mention de la délivrance du brevet :
**20.10.93 Bulletin 93/42**

(84) Etats contractants désignés :
**DE FR GB IT NL**

(56) Documents cités :
**FR-A- 2 329 110**
**US-A- 3 681 699**
**US-A- 3 729 666**
**NUCLEAR INSTRUMENTS AND METHODS.**
**vol. 37, no. 1, novembre 1965, AMSTERDAM**
**NL pages 58 - 60; E. Elad, S. Rozen: "A**
**Transistorized Linear Gate"**

(73) Titulaire : **SGS-THOMSON MICROELECTRONICS S.A.**
**7, Avenue Gallièni**
**F-94250 Gentilly (FR)**

(72) Inventeur : **Perroud, Philippe**
**2, Impasse des Lécheres**
**F-38240 Meylan (FR)**
Inventeur : **Jaffard, Jean-Luc**
**4bis, Rue du Cotaire**
**F-38120 Saint Egreve (FR)**

(74) Mandataire : **de Beaumont, Michel**
**1bis, rue Champollion**
**F-38000 Grenoble (FR)**

**Description**

La présente invention concerne des circuits d'amplification de tension à sortie en courant, et plus particulièrement des circuits d'amplification destinés à commander des têtes de magnétoscope de caractéristiques différentes.

Certains magnétoscopes comprennent quatre têtes, deux pour un mode de fonctionnement "durée normale" et deux pour un mode de fonctionnement "longue durée". Ces quatre têtes servent aussi bien pour l'enregistrement que pour la lecture. En fonctionnement, les deux têtes associées au mode sélectionné se remplacent l'une l'autre pour enregistrer ou lire des données sur une bande magnétique.

Lors d'un enregistrement, des signaux en tension destinés à être enregistrés sont envoyés par un processeur de signal vers un circuit d'amplification qui comporte des sorties en courant reliées aux têtes de magnétoscope.

On cherche dans un tel circuit d'amplification à optimiser et à déterminer de façon précise la transconductance qui est le rapport entre le courant de sortie et la tension d'entrée pour obtenir une qualité d'enregistrement optimale. On cherche également à déterminer de façon précise l'impédance d'entrée pour réaliser une bonne adaptation d'impédance.

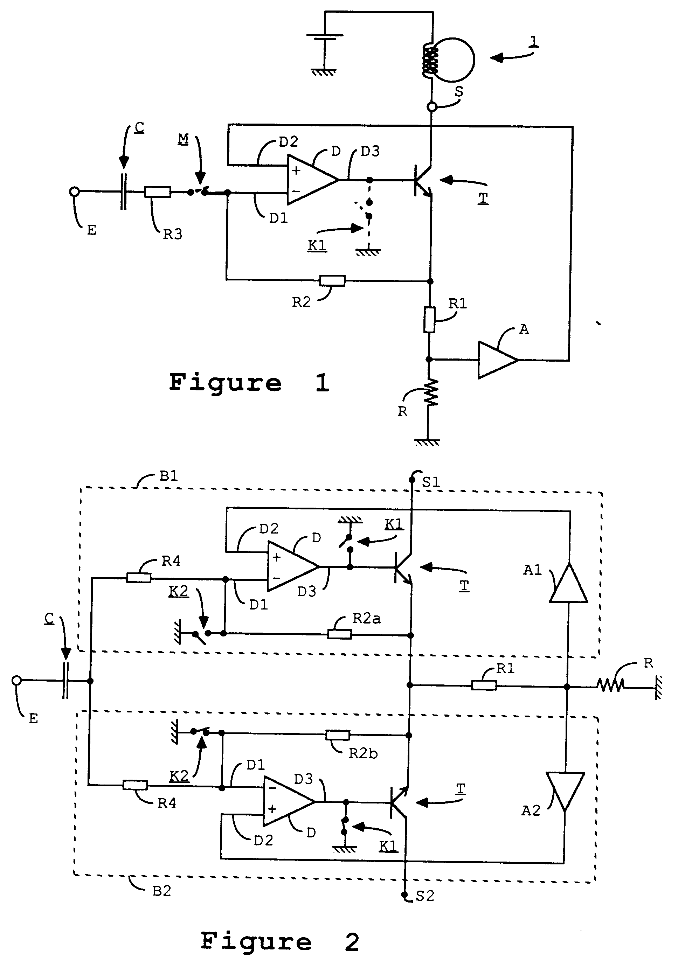

Un circuit d'amplification pour une tête qui répond à ces deux critères est mentionné dans le Digest de ICCF 1988. Il est représenté sur la figure 1. Une capacité de couplage C est connectée à la borne d'entrée E du circuit et ne laisse passer que les signaux haute fréquence. Un amplificateur différentiel D a une première entrée D1 reliée à la capacité de couplage par l'intermédiaire d'une résistance R3, et sa sortie D3 est connectée à la base d'un transistor NPN dont le collecteur est connecté à la borne de sortie S elle-même reliée à une tête de magnétoscope 1. Un amplificateur A a son entrée connectée, d'une part, à l'émetteur du transistor par l'intermédiaire d'une résistance R1, d'autre part, à la masse par l'intermédiaire d'une résistance de protection R, et sa sortie connectée à la deuxième entrée D2 de l'amplificateur différentiel. Une résistance R2 est connectée entre l'entrée D1 de l'amplificateur différentiel et l'émetteur du transistor.

La transconductance Tr de ce circuit, dans le cas où le gain de l'amplificateur A est R3/(R2+R3), est donnée par :

$$Tr = (R1 + R2)/(R1 \times R3) \quad (1)$$

On choisit per exemple les valeurs R1 = 10 Ω, R2 = 1 kΩ et R3 = 1,5 kΩ pour optimiser cette transconductance. De plus, les résistances R1, R2 et R3 sont externes et non intégrées pour être définies avec une grande précision et pour que la transconductance soit elle-même déterminée de façon précise. Pour ce circuit, on s'affranchit dans le calcul de la transconductance de la résistance de protection R qui est intégrée et définie avec une moins grande précision.

L'impédance d'entrée de ce circuit est égale à R3.

Une façon de réaliser un circuit d'amplification permettant de commander une parmi deux têtes de caractéristiques différentes est de prévoir deux circuits élémentaires semblables à celui de la figure 1 présentant, d'une part, une borne d'entrée et une capacité de couplage communes, d'autre part, une résistance R et une résistance R1 communes. Les amplificateurs différentiels et les transistors sont les mêmes dans les deux circuits élémentaires. L'amplificateur A devient un amplificateur A1 dans l'un des circuits élémentaires et un amplificateur A2 différent dans l'autre. Ces amplificateurs A1 et A2 ont leurs entrées connectées l'une à l'autre. Chacune des deux sorties des circuits est reliée à une tête différente.

Un interrupteur K1, représenté en pointillés sur la figure 1, est rajouté dans chacun des circuits élémentaires. Il est connecté entre la base du transistor et la masse, et il est constitué d'un transistor unique qui est mis en état de saturation en position fermée.

On peut de plus rajouter un commutateur externe entre la capacité de couplage commune et les deux résistances R3, mais un tel commutateur est coûteux et non intégré. Une autre solution consiste à rajouter à la place du commutateur externe un interrupteur M représenté en pointillés entre la résistance R3 et l'entrée D1 de l'amplificateur différentiel dans chaque circuit élémentaire. Il peut être intégré mais, comme il n'a pas de borne à la masse, doit être constitué d'un circuit à plusieurs transistors (sept transistors).

Pour enregistrer sur une tête, on ferme l'interrupteur M et on ouvre l'interrupteur K1 du circuit associé à la tête sélectionnée, et l'on met en position inverse les interrupteurs du circuit que l'on souhaite rendre inactif. Le fait de fermer un interrupteur K1 relie la base du transistor à la masse et plus aucun courant ne circule dans ce transistor.

Si l'on choisit deux résistances R3 identiques à celle de la figure 1, l'impédance d'entrée sera toujours égale à R3/2 lorsque l'un ou l'autre des sous-circuits élémentaires sera rendu inactif.

Si l'on considère dans le circuit élémentaires comportant l'amplificateur A1 une résistance R2a et dans l'autre circuit élémentaire une résistance différente R2b à la place de la résistance R2, et si l'on choisit les gains des amplificateurs A1 et A2 égaux à R3/(R2a+R3) et R3/(R2b+R3), respectivement, on obtient deux transconductances indépendantes de R :

$$Tra = (R1 + R2a)/(R1 \times R3)$$
$$Trb = (R1 + R2b)/(R1 \times R3)$$

Cependant, le fait de prévoir un interrupteur M intégré rajoute une broche d'accès supplémentaire pour chaque circuit élémentaire. En effet, les résistances R2a, R2b et R3 sont externes. Ainsi, il est prévu une broche d'accès entre la résistance R3 et le circuit intégré, et une broche entre le circuit intégré et la borne de la résistance R2a (R2b) reliée à l'entrée D1 de l'amplificateur différentiel. Sans cet interrupteur M, les résistances R3 et R2 étaient connectées ensemble et une seule broche était nécessaire pour les relier à l'entrée D1.

Ainsi, un objet de la présente invention est de prévoir un circuit d'amplification à impédance d'entrée déterminée à deux valeurs de transconductance différentes dans lequel aucune broche d'accès supplémentaire n'est rajoutée.

Un autre objet de l'invention est de prévoir un tel circuit d'amplification comprenant moins de transistors.

Pour atteindre ces objets, la présente invention prévoit un circuit d'amplification de tension à sortie en courant entre une borne d'entrée et l'une ou l'autre de première et deuxième bornes de sortie comprenant des premier et deuxième sous-circuits qui comportent chacun un premier amplificateur différentiel dont une première entrée est reliée à la borne d'entrée par l'intermédiaire d'une première résistance, un transistor dont la base est connectée à la sortie de l'amplificateur différentiel, et un premier interrupteur connecté entre la base du transistor et la masse. Le premier sous-circuit comprend également un deuxième amplificateur dont la sortie est connectée à la deuxième entrée de l'amplificateur différentiel, et une deuxième résistance connectée entre l'émetteur du transistor et la première entrée de l'amplificateur différentiel. Le deuxième sous-circuit comprend également un troisième amplificateur dont la sortie est connectée à la deuxième entrée de l'amplificateur différentiel, et une troisième résistance connectée entre l'émetteur du transistor et la première entrée de l'amplificateur différentiel. Les collecteurs des transistors des premier et deuxième sous-circuits sont connectés aux première et deuxième bornes de sortie, respectivement, et les entrées des deuxième et troisième amplificateurs sont reliées, d'une part, à la masse par l'intermédiaire d'une quatrième résistance commune, d'autre part, aux émetteurs des deux transistors par l'intermédiaire d'une cinquième résistance commune. Les premier et deuxième sous-circuits comprennent chacun en outre un deuxième interrupteur connecté entre la première entrée de l'amplificateur différentiel et la masse, chacun de ces deuxièmes interrupteurs étant constitué par un transistor unique mis en état de saturation en position fermée.

Ces objets, caractéristiques et avantages ainsi que d'autres de la présente invention seront exposés plus en détail dans la description suivante d'un mode de réalisation particulier faite en relation avec les figures jointes parmi lesquelles :

la figure 1, déjà décrite, représente un circuit d'amplification à une sortie selon l'art antérieur ; et

la figure 2 représente un circuit d'amplification à deux sorties selon la présente invention.

La figure 2 représente un circuit d'amplification de tension à sortie en courant entre une borne d'entrée E et l'une ou l'autre de deux bornes de sortie S1 et S2 selon la présente invention, deux têtes aux caractéristiques différentes étant reliées chacune à une sortie S1 ou S2. Deux sous-circuits B1 et B2 comprennent chacun un amplificateur différentiel D dont une première entrée D1 est reliée, par l'intermédiaire d'une résistance R4, à une borne d'une capacité de couplage C dont l'autre borne est connectée à l'entrée E du circuit. Chaque sous-circuit comporte également un transistor T dont la base est connectée à la sortie D3 de l'amplificateur différentiel, et un interrupteur K1 qui est connecté entre la base du transistor et la masse et qui peut donc être constitué par un transistor unique mis en état de saturation en position fermée.

De plus, les sous-circuits B1 et B2 comprennent chacun un amplificateur A1, A2, respectivement, dont la sortie est connectée à la deuxième entrée D2 de l'amplificateur différentiel associé. Ils comportent également chacun une résistance R2a, R2b, respectivement, connectée entre l'émetteur du transistor associé et la première entrée D1 de l'amplificateur différentiel correspondant.

Les collecteurs des transistors des deux sous-circuits B1, B2 sont reliés chacun à une borne de sortie S1, S2, respectivement. Les entrées des amplificateurs A1 et A2 sont reliées, d'une part, à la masse par l'intermédiaire d'une résistance de protection R commune, d'autre part, aux émetteurs des deux transistors par l'intermédiaire d'une résistance R1 commune.

Les deux sous-circuits comprennent chacun en outre un interrupteur K2 qui est connecté entre l'entrée D1 de l'amplificateur différentiel et la masse et qui est constitué par un transistor unique mis en état de saturation en position fermée.

Sur la figure 2, les interrupteurs K1 et K2 du sous-circuit B2 sont fermés. La base du transistor T est donc à la masse et aucun courant ne circule dans ce transistor. Par contre, les interrupteurs K1 et K2 du sous-circuit B1 sont ouverts. Cette configuration correspond à un sous-circuit B1 actif et un sous-circuit B2 inactif.

Dans ce cas, la somme des résistances R et R1 est en parallèle avec la résistance R2b. Ces résistances ont par exemple les valeurs suivantes : $R = 1 \, \Omega$, $R1 = 10 \, \Omega$ et $R2b = 1 \, k\Omega$. La résistance équivalente est ainsi sensiblement égale à $R+R1$. La transconductance Tr1 associée au sous-circuit B1 s'obtient donc en remplaçant dans la relation (1) la résistance R2 par la résistance R2a, à condition de prendre comme gain de l'amplificateur A1 la quantité R4/(R2a+R4) :

$$Tr1 = (R1 + R2a)/(R1 \times R4).$$

En outre, l'impédance d'entrée du circuit d'amplification peut se déduire à partir de celle du circuit de la figure 1 en faisant correspondre la résistance R4 du sous-circuit B1 à la résistance R3 et en ajoutant en parallèle la résistance R4 du sous-circuit B2. En choisissant les deux résistances R4 identiques, l'impédance d'entrée est alors égale à R4/2.

Pour rendre actif le sous-circuit B2 et inactif le sous-circuit B1, on ferme les interrupteurs K1 et K2 du sous-circuit B1 et on ouvre les interrupteurs K1 et K2 du sous-circuit B2. La transconductance associée au sous-circuit B2, à condition de choisir le gain de l'amplificateur A2 égal à la quantité R4/(R2b+R4), est alors :

$$Tr2 = (R1 + R2b)/(R1 \times R4).$$

L'impédance d'entrée est toujours R4/2.

Le circuit d'amplification présente ainsi deux transconductances différentes qui peuvent être optimisées pour chacune des têtes par le choix adapté des résistances R2a et R2b. Ces deux transconductances ne dépendent pas de la résistance de protection R intégrée et elles peuvent être déterminées de façon précise en choisissant des résistances R1, R2a, R2b et R4 externes.

L'impédance d'entrée est également déterminée et est égale à R4/2. On peut choisir R4 = 2xR3 pour se ramener à l'impédance d'entrée du circuit de la figure 1.

Le transistor unique formant chacun des interrupteurs K2 peut être intégré et son implantation ne nécessite aucune broche supplémentaire puisqu'il est directement connecté d'une part à une entrée de l'amplificateur différentiel associé qui est lui-même intégré et d'autre part à la masse.

Le nombre de transistors dans le circuit de la figure 2 est de plus réduit puisque deux interrupteurs à un transistor unique remplacent deux interrupteurs à sept transistors.

## Revendications

1. Circuit d'amplification de tension à sortie en courant entre une borne d'entrée (E) et l'une ou l'autre de première et deuxième bornes de sortie (S1, S2) comprenant des premier et deuxième sous-circuits (B1, B2) qui comportent chacun :

   un premier amplificateur différentiel (D) dont une première entrée (D1) est reliée à la borne d'entrée par l'intermédiaire d'une première résistance (R4),

   un transistor (T) dont la base est connectée à la sortie (D3) de l'amplificateur différentiel,

   un premier interrupteur (K1) connecté entre la base du transistor et la masse,

   le premier sous-circuit comprenant également un deuxième amplificateur (A1) dont la sortie est connectée à la deuxième entrée (D2) de l'amplificateur différentiel, et une deuxième résistance (R2a) connectée entre l'émetteur du transistor et la première entrée de l'amplificateur différentiel,

   le deuxième sous-circuit comprenant également un troisième amplificateur (A2) dont la sortie est connectée à la deuxième entrée de l'amplificateur différentiel, et une troisième résistance (R2b) connectée entre l'émetteur du transistor et la première entrée de l'amplificateur différentiel,

   les collecteurs des transistors des premier et deuxième sous-circuits étant connectés aux première et deuxième bornes de sortie, respectivement, et les entrées des deuxième et troisième amplificateurs étant reliées, d'une part, à la masse par l'intermédiaire d'une quatrième résistance (R) commune, d'autre part, aux émetteurs des deux transistors par l'intermédiaire d'une cinquième résistance (R1) commune,

   caractérisé en ce que les premier et deuxième sous-circuits comprennent chacun en outre un deuxième interrupteur (K2) connecté entre la première entrée de l'amplificateur différentiel et la masse, chacun de ces deuxièmes interrupteurs étant constitué par un transistor unique mis en état de saturation en position fermée.

2. Circuit d'amplification selon la revendication 1, caractérisé en ce que les première et deuxième bornes de sortie (S1, S2) sont chacune connectées à une tête de magnétoscope différente adaptée à un mode de fonctionnement "durée normale" ou bien un mode de fonctionnement "longue durée".

3. Circuit d'amplification selon la revendication 1, caractérisé en ce que les gains des deuxième et troisième amplificateurs (A1, A2) sont égaux à R4/(R2a+R4) et R4/(R2b+R4), respectivement.

4. Circuit d'amplification selon la revendication 1, caractérisé en ce que chacun des premiers interrupteurs (K1) est constitué par un transistor unique mis en état de saturation en position fermée.

## Patentansprüche

1. Spannungs-Strom-Verstärkungsschaltung, die zwischen einem Anschluß (E) und einem ersten oder einem zweiten Ausgangsanschluß (S1, S2) angeschlossen ist und einen ersten und einen zweiten Unterschaltkreis (B1, B2) aufweist, wobei jeder der Unterschaltkreise folgende Merkmale aufweist:
   einen ersten Differentialverstärker (D), dessen erster Eingang (D1) über einen ersten Widerstand (R4) mit dem Eingangsanschluß verbunden ist,
einen Transistor (T), dessen Basis mit dem Ausgang (D3) des Differentialverstärkers verbunden ist,
einen ersten Schalter (K1), der zwischen der Basis des Transistors und Masse angeschlossen ist,
wobei der erste Unterschaltkreis ferner einen zweiten Verstärker (A1) aufweist, dessen Ausgang mit dem zweiten Eingang (D2) des Differentialverstärkers verbunden ist, sowie einen zweiten Widerstand (R2a), der zwischen dem Emitter des Transistors und dem ersten Eingang des Differentialverstärkers angeschlossen ist,
wobei der zweite Unterschaltkreis ferner einen dritten Verstärker (A2) aufweist, dessen Ausgang mit dem zweiten Eingang des Differentialverstärkers verbunden ist, sowie einen dritten Widerstand (R2b), der zwischen dem Emitter des Transistors und dem ersten Eingang des Differentialverstärkers angeschlossen ist,
wobei die Kollektoren der Transistoren des ersten und des zweiten Unterschaltkreises mit dem ersten bzw. dem zweiten Ausgangsanschluß verbunden sind und die Eingänge des zweiten und des dritten Verstärkers einerseits über einen gemeinsamen vierten Widerstand (R) mit Masse und andererseits über einen gemeinsamen fünften Widerstand (R1) mit den Emittern der beiden Transistoren verbunden sind,
dadurch **gekennzeichnet,** daß sowohl der erste als auch der zweite Unterschaltkreis einen zweiten Schalter (K2) aufweist, der zwischen dem ersten Eingang des Differentialverstärkers und Masse angeschlossen ist, wobei diese zweiten Schalter durch einen einzelnen Transistor gebildet sind, der beim Anschalten im Sättigungsmodus ist.

2.  Verstärkungsschaltung nach Anspruch 1, dadurch **gekennzeichnet,** daß der erste und der zweite Ausgangsanschluß (S1, S2) mit unterschiedlichen Videorecorder-Köpfen verbunden sind, welche an einen "normale Dauer"- oder "lange Dauer"-Modus angepaßt sind.

3.  Verstärkungsschaltung nach Anspruch 1, dadurch **gekennzeichnet,** daß die Verstärkungsfaktoren des zweiten und des dritten Verstärkers (A1, A2) gleich R4/(R2a+R4) bzw. R4/(R2b+R4) sind.

4.  Verstärkungsschaltung nach Anspruch 1, dadurch **gekennzeichnet,** daß jeder erste Schalter (K1) durch einen einzelnen Transistor gebildet ist, der beim Einschalten im Sättigungsmodus ist.

## Claims

1.  A voltage-current amplification circuit connected between a terminal (E) and first or second output terminals (S1, S2) including first and second sub-circuits (B1, B2), each of which includes:

    a first differential amplifier (D), a first input (D1) of which is connected to the input terminal through a first resistor (R4),

    a transistor (T), the base of which is connected to the output (D3) of the differential amplifier,

    a first switch (K1) connected between the transistor base and ground,

    the first sub-circuit also including a second amplifier (A1), the output of which is connected to the second input (D2) of the differential amplifier, and a second resistor (R2a) connected between the transistor emitter and the first input of the differential amplifier,

    the second sub-circuit also including a third amplifier (A2), the output of which is connected to the second input of the differential amplifier, and a third resistor (R2b) connected between the transistor emitter and the first input of the differential amplifier,

    the transistor collectors of the first and second sub-circuits being connected to the first and second output terminals, respectively, and the inputs of the second and third amplifiers being connected, on the one hand, to ground through a common fourth resistor (R) and, on the other hand, to the emitters of the two transistors through a fifth common resistor (R1),

    characterized in that each first and second sub-circuit further includes a second switch (K2) connected between the first input of the differential amplifier and ground, each of said second switches being formed by a single transistor in the saturation mode when switched on.

2.  An amplification circuit according to claim 1, characterized in that each first and second output terminal (S1, S2) is connected to a different VTR head adapted to a "normal duration" or "long duration" mode.

3.  An amplification circuit according to claim 1, characterized in that the gains of the second and third amplifiers (A1, A2) are equal to R4/(R2a+R4) and R4/(R2b+R4), respectively.

4.  An amplification circuit according to claim 1, characterized in that each first switch (K1) is formed by a single transistor in the saturation mode when switched on.

Figure 1

Figure 2